# EUROPÄISCHE PATENTSCHRIFT

(11) **EP 0 775 368 B1**
(45) Veröffentlichungstag und Bekanntmachung des Hinweises auf die Patenterteilung: **02.12.1998**
(21) Anmeldenummer: 95929088.3
(22) Anmeldetag: 05.08.1995
(51) Int. Cl.: H01L 23/055, H01L 23/495

(54) **TRÄGER AUS EINEM KUNSTSTOFF FÜR EINE ELEKTRONISCHE SCHALTUNG MIT BONDBAREN KONTAKTSTIFTEN**
PLASTIC SUBSTRATE FOR ELECTRONIC CIRCUITS WITH BONDABLE CONTACT PINS
SUPPORT EN MATIERE PLASTIQUE POUR CIRCUITS ELECTRONIQUES A BROCHES DE CONTACT PERMETTANT DE REALISER DES LIAISONS

(30) Priorität: 10.08.1994 DE 4428319
(43) Veröffentlichungstag der Anmeldung: 28.05.1997
(73) Patentinhaber: DODUCO GmbH, 75181 Pforzheim (DE)
(72) Erfinder: SCHULZE, Gunter, D-75228 Ispringen (DE); GEBHARD, Reiner, D-75239 Eisingen (DE)
(74) Vertreter: Twelmeier, Ulrich, Dipl.Phys.
(86) Internationale Anmeldenummer: EP9503121
(87) Internationale Veröffentlichungsnummer: WO9605615

(56) Entgegenhaltungen:
- EP-A- 0 036 671
- DE-A- 2 212 629
- FR-A- 2 121 744
- PATENT ABSTRACTS OF JAPAN vol. 7, no. 178 (E-191) (1323) 6. August 1983 & JP,A,58 082 543 (HITACHI) 18. Mai 1983

## Beschreibung

Die Erfindung geht aus von einem Träger mit den im Oberbegriff des Anspruchs 1 angegebenen Merkmalen. Ein solcher Träger ist insbesondere als Teil eines Gehäuses bekannt, welches die elektronische Schaltung aufnimmt, z. Bsp. als Gehäuseunterteil, welches durch ein Gehäuseoberteil zu einem allseits geschlossenem Gehäuse ergänzt wird. Ein derartiges Gehäuse ist z. Bsp. aus Fr-A-2 121 744 bekannt. Um die gewünschten elektrischen Verbindungen zur Schaltung herstellen zu können, sind Kontaktstifte vorgesehen, welche den Träger durchsetzen. Auf einer ersten Seite des Trägers - im Falle eines Gehäuses ist es eine Gehäuseinnenseite - haben die Kontaktstifte einen bondbaren Abschnitt mit einer Bondfläche, mit welcher die Schaltung jeweils mittels eines Drahtes durch bonden (Reibschweißen) verbunden werden kann. Auf einer der ersten Seite des Trägers abgewandten zweiten Seite des Trägers (im Falle eines Gehäuses eine Gehäuseaußenseite) ragen die Kontaktstifte ins Freie und können dort durch Löten oder Steckverbinden mit einer Stromversorgungseinheit, mit weiteren Schaltungen und/oder Sensoren verbunden werden.

Es ist bekannt, die Kontaktstifte L-förmig abgewinkelt auszubilden und beim Herstellen des Trägers durch Spritzgießen mit dem Kunststoff des Trägers zu umspritzen. Das hat verschiedene Nachteile: Die Bondfläche, sie besteht überlicherweise aus einer dünnen Feingoldschicht, kann durch die Handhabungsvorgänge beim Spritzgießen und durch das Spritzgießen beeinträchtigt werden, was unzuverlässige Bondverbindungen mit der Folge erhöhter Ausfallraten zur Folge hat. Dem könnte man dadurch entgehen, daß man die Bondfläche durch Abscheiden von Feingold auf die Kontaktstifte erst herstellt, nachdem diese in den Träger eingebettet sind. Das erfordert jedoch eine aufwendige Einzelteilbeschichtung, wohingegen dann, wenn die Kontaktstifte schon vor dem Einbetten in den Träger mit Feingold beschichtet werden, die Beschichtung rationell auf einem vorgestanzten Band vergenommen werden kann, von welchem die Kontaktstifte anschließend abgetrennt werden. Ein weiterer Nachteil der bekannten Vorgehensweise liegt darin, daß die umgebogenen Abschnitte der Kontaktstifte, welche die Bondfläche tragen, keinen festen Verbund mit dem durch Spritzgießen hergestellten Träger eingehen; sie können deshalb beim Reibschweißen schwingen, was ebenfalls zu unzuverlässigen Bondverbindungen führen kann.

Die ältere am 14/6/95 veröffentlichte europäische Anmeldung EP-A-0 657 931 zeigt ein geschlossenes Gehäuse aus Kunststoff, wobei einzelne der Anschlußteile U-Förmig ausgebildet sind, um den chip an seiner Seite oder Ecke zu unterstützen.

Der vorliegenden Erfindung liegt die Aufgabe zugrunde, einen Kunststoffträger mit Kontaktstiften der eingangs genannten Art dahingehend zu verbessern, daß ohne größeren Aufwand Bondverbindungen mit höherer Zuverlässigkeit hergestellt werden können.

Diese Aufgabe wird gelöst durch einen Träger mit den im Anspruch 1 angegebenen Merkmalen. Vorteilhafte Weiterbildungen der Erfindung sind Gegenstand der abhängigen Ansprüche.

Erfindungsgemäß sind die Kontaktstifte nicht L-förmig, sondern U-förmig gebogen, und zwar in der Weise, daß zwei ungleich lange Schenkel entstehen, die durch den bondbaren Abschnitt des Kontaktstiftes miteinander verbunden sind. Der längere der beiden Schenkel durchsetzt den Träger und dient wie beim Stand der Technik auf der zweiten Seite des Trägers, welche dem bondbaren Abschnitt der Konaktfeder abgewandt ist, als Löt- oder Steckkontaktanschluß, um die elektronische Schaltung, welche auf der anderen Seite des Trägers durch Bonden mit den Kontaktstiften verbunden sind, mit einer Stromquelle, einer anderen Schaltung und/oder einem Sensor zu verbinden. Der kurze Schenkel des jeweiligen Kontaktstiftes dringt ebenfalls in den Träger ein, aber vorzugsweise ohne ihn zu durchdringen und steckt deshalb vorzugsweise in einem Sackloch, welches in dem Fall, daß der Träger Bestandteil eines Gehäuses ist, keinerlei Abdichtung nach außen bedarf, um das Gehäuse dicht zu erhalten. Zwar könnte man solche U-förmige Kontaktstifte im Prinzip auch in den Kunststoffträger einspritzen, doch ist es zur Lösung der gestellten Aufgabe viel vorteilhafter, den Träger zunächst ohne die Kontaktstifte durch Spritzgießen herzustellen, dabei die für die Aufnahme der Kontaktstifte erforderlichen Löcher - für jeden Kontaktstift ein Sackloch und ein durchgehendes Loch - beim Spritzgießen zu formen und in die vorgeformten Löcher die U-förmigen umgebogenen Kontaktstifte nachträglich einzupressen. Dadurch werden mehrere Vorteile erzielt:
- Das Spritzgießen wird vereinfacht; man benötigt keine Vorrichtungen zum Einlegen und Positionieren der Kontaktstifte in der Spritzgießform.
- Risse und Spalten, die durch Schrumpfen des Kunststoffes im Bereich der Kontaktstifte entstehen können, wenn diese eingespritzt werden, treten erfindungsgemäß nicht auf.
- Dadurch, daß die Kontaktstifte den Spritzgießvorgang nicht miterleben, können die Bondflächen durch Abscheiden von Feingold bereits vorher auf vorgestanztem bandförmigen Halbzeug gebildet werden und diese Bondflächen können durch den Spritzgießvorgang nicht beeinträchtigt werden.
- Dadurch, daß der bondbare Abschnitt der Kontaktstifte an beiden Enden in einen Schenkel übergeht, der im Kunststoff des Trägers steckt, ist der bondbare Abschnitt sehr stabil und die Bondfläche kann nicht schwingen, was eine erstklassige Bedingung für zuverlässige Bondverbindungen ist.

In diesem Zusammenhang wird es bevorzugt, wie beim Stand der Technik, Kontaktstifte zu verwenden, die eine flaches, insbesondere rechteckiges Profil haben, welches man bei Verwendung von bandförmigem Halbzeug ohne weiteres erhält, und dann den bondbaren Abschnitt so dicht an der ersten Seite des Trägers anzuordnen, wie es die Biegeradien des Kontaktstiftes erlauben. Die beiden Schenkel des Kontaktstiftes stecken dann so tief wie möglich im Träger und bewirken eine hohe mechanische Stabilität des bondbaren Abschnittes, die mit Vorteil noch dadurch erhöht wird daß die erste Seite des Trägers, welche dem bondbaren Abschnitt zugewandt ist, diesen mechanisch unterstützt, was z. Bsp. dadurch begünstigt werden kann, daß man die erste Seite des Trägers in dem Abschnitt, in welchem der bondbare Abschnitt der Kontaktstifte liegen soll, der Kontur des bondbaren Abschnittes angepaßt etwas ballig spritzt.

Wenn man die Kontaktstifte in Anwendung bekannter Einpreßtechniken in den Träger einpreßt, lassen sich ein ausreichender Festsitz und eine für viele Anwendungen ausreichende Dichtigkeit erreichen. Der Festsitz kann in vorteilhafter Weise dadurch erhöht werden, daß die Kontaktstifte, jedenfalls ihr längerer Schenkel, in ihrem im Träger verlaufenden Abschnitt gezahnte Ränder haben und daß der längere Schenkel mit einem spitz zulaufenden Abschnitt im Träger steckt, der sich bei fortschreitendem Einpressen nur um so fester und dichter in das Loch des Trägers einfügt.

Die Dichtigkeit des Trägers kann dadurch erhöht werden, daß man die Kontaktstifte auf der ersten Seite des Trägers bis unterhalb der Bondfläche ihres bondbaren Abschnittes, so daß die Bondfläche frei bleibt, in ein Gießharz einbettet. Um dies zu erleichtern, sieht man zweckmäßigerweise eine Vertiefung auf der ersten Seite des Trägers vor, in welcher die bondbaren Abschnitte der Kontaktstifte liegen. Eine andere Möglichkeit, die Dichtigkeit der Verbindung zwischen Träger und Kontaktstiften zu erhöhen, besteht darin, den längeren Schenkel der Kontaktstifte in jenem Abschnitt, welcher im Träger liegen soll, mit einem Schmelzkleber zu umgeben und diesen Schmelzkleber nach dem Einpressen der Kontaktstifte in den Träger durch Wärmezufuhr zu aktivieren.

Die Bondflächen der Kontaktstifte können einen üblichen Aufbau haben; sie bestehen zweckmäßigerweise aus einer dünnen Feingoldschicht über einer Nickelzwischenschicht. Wenn die auf der anderen Seite des Trägers hervorstehenden längeren Schenkel der Kontaktstifte durch Löten mit elektrischen Zuleitungen verbunden werden sollen, dann sind sie in ihrem hervorstehenden Abschnitt zweckmäßigerweise mit einer weichlötbaren Schicht versehen, z.Bsp. aus einer an sich bekannten Zinn-blei-Legierung.

Ein Ausführungsbeispiel der Erfindung ist in den beigefügten Zeichnungen dargestellt und wird nachstehend beschrieben.
- Figur 1: zeigt die Draufsicht auf einen Träger aus Kunststoff mit 6 eingesetzten Kontaktstiften,
- Figur 2: zeigt die Unteransicht desselben Trägers,
- Figur 3: zeigt den Schnitt III-III durch denselben Träger,
- Figur 4: zeigt als Detail eine Ansicht eines Kontaktstiftes, bevor er U-förmig umgebogen wurde,
- Figur 5: zeigt als Detail eine Ansicht von 3 Kontaktstiften, in einem bandförmigen Halbzeug zusammenhängend,
- Figur 6: zeigt die Draufsicht auf die in Figur 5 dargestellten Kontaktstifte, und
- Figur 7: zeigt die Seitenansicht gemäß Pfeil VII auf die in Figur 5 dargestellten Kontaktstifte.

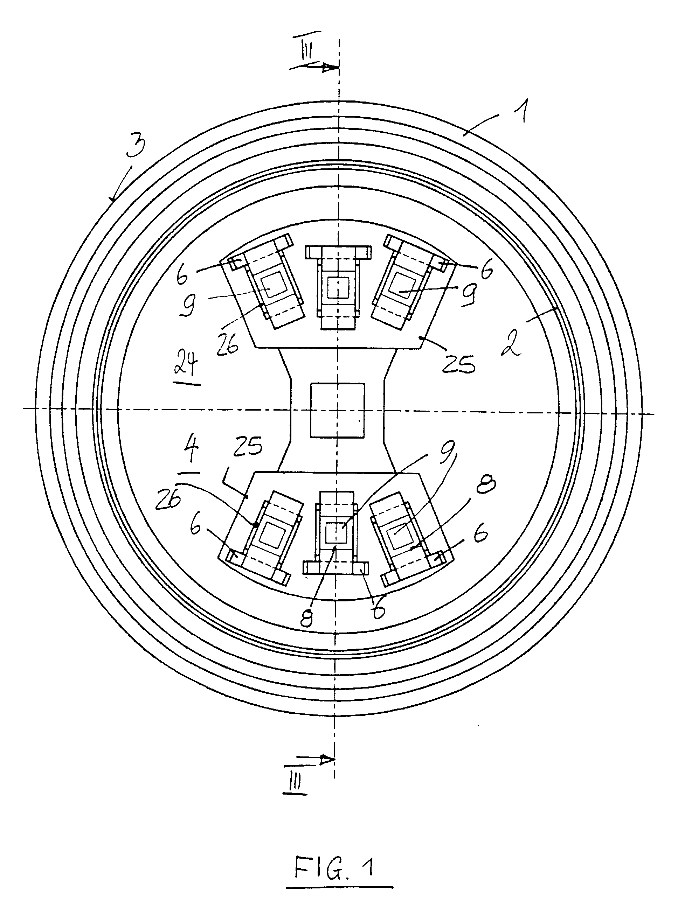

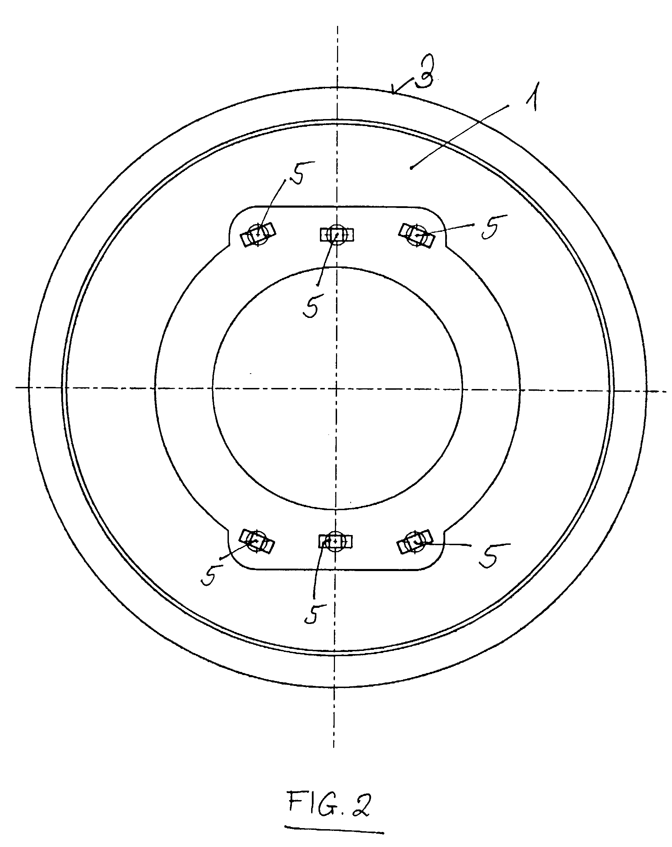

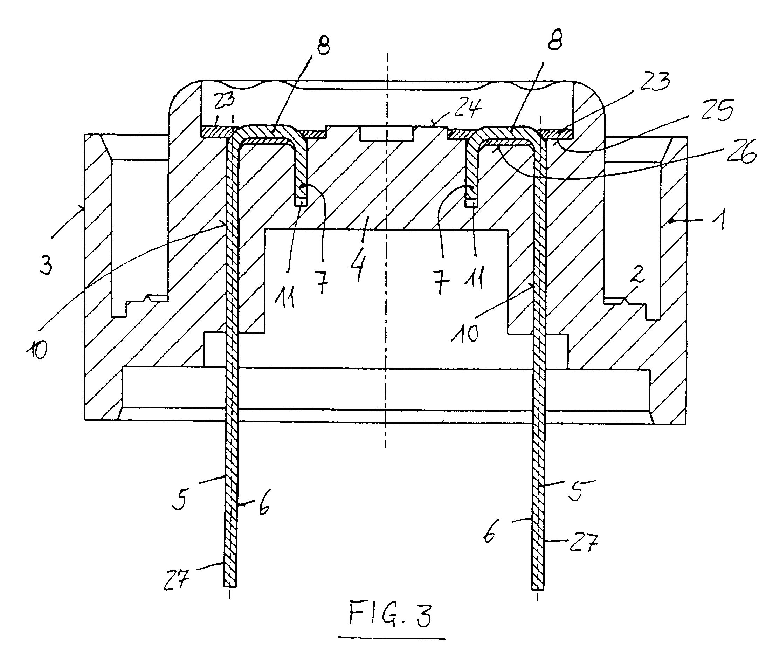

Der in den Figuren 1 - 3 dargestellte Träger (1) ist das Unterteil eines Gehäuses. Das Oberteil, durch welches es zum Gehäuse ergänzt wird, ist nicht dargestellt, wohl aber ein ringförmiger Vorsprung (2),auf welchen das Oberteil des Gehäuses mit seinem unteren Rand aufgesetzt wird; der ringförmige Vorsprung (2)dient dazu, die beiden Gehäuseteile durch Ultraschallschweißen miteinander zu verbinden.

Der Träger hat eine zylindrische Mantelfläche (3) und einen kräftigen Boden (4), in welchen 6 Kontaktstifte (5) eingepreßt sind. Die Kontaktstifte sind U-förmig abgewinkelt und bestehen aus einem langen Schenkel (6), einem kurzen Schenkel (7) und aus einem diese beiden Schenkel verbindenden Abschnitt (8) mit einem bondbaren Oberflächenbereich (9).

Zur Aufnahme der Kontaktstifte (5) hat der Träger (1) 6 durchgehende Löcher (10), in welchen die langen Schenkel (6) stecken, und 6 Sacklöcher (11), in welchen die kurzen Schenkel (7) stecken.

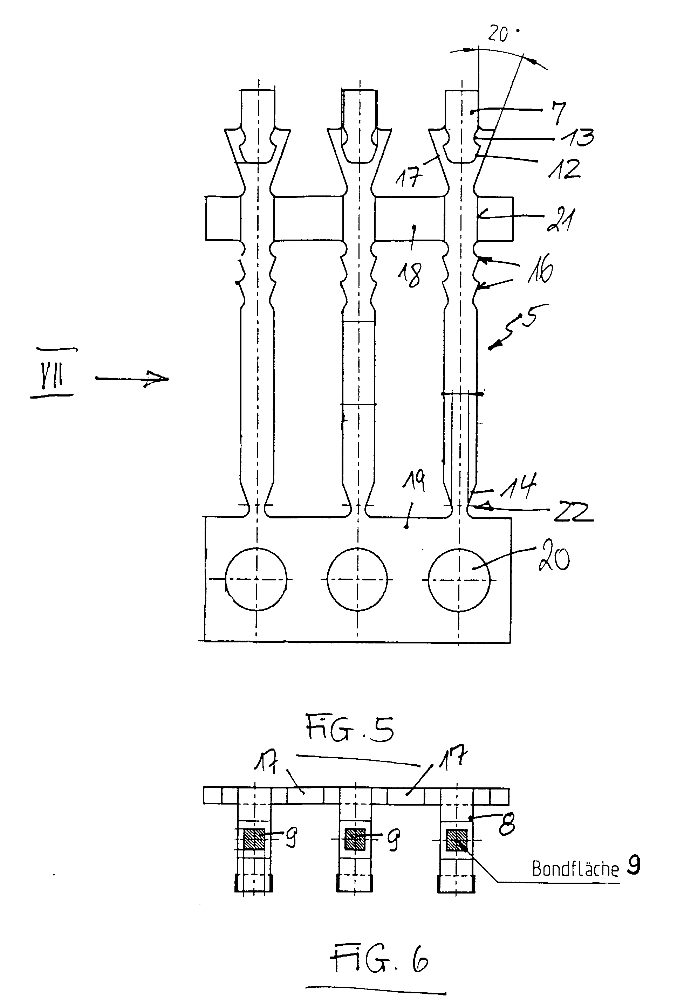

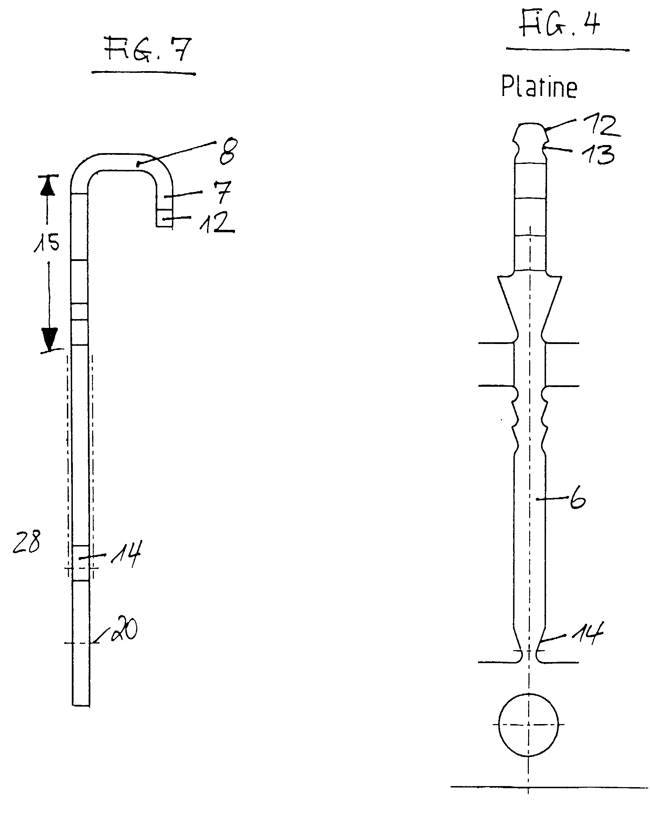

Wie die Figuren 4 - 7 zeigen, haben die kurzen Schenkel (7) eine Einführfase (12), welche das Einführen des kurzen Schenkels in sein Sackloch (11) erleichtert, und anschließend an die Einführfase (12) eine Taille (13), welche beim Einpressen in das Sackloch (11) eine Verzahnung mit dem Kunststoff des Trägers (1) bewirkt. Auch der lange Schenkel (6) hat an seiner Spitze eine Einführfase (14) und in dem Bereich (15), welcher dazu bestimmt ist, im Kunststoff des Trägers (1) eingebettet zu sein, eine Reihe von Zähnen (16) zur verzahnung mit dem Kunststoff im Loch (10) sowie einen spitz zulaufenden Abschnitt (17) zum Einpressen in den oberen Einführbereich des jeweiligen Loches Zähne.

Die Kontaktstifte werden aus bandförmigem Halbzeug hergestellt, welches vorgestazzt ist und in welchem sie durch Stege (18) und einen Seitenstreifen (19) mit Transportlöchern (20) zunächst verwunden sind. Als bandförmiges Halbzeug können sie u.e. aer Einwirkung galvanischer Bäder ausgesetzt werden, um auf den Abschnitten (8) selektiv zunächst eine Nickelschicht abzuscheiden, vorzugsweise 3-4mm dick, und darauf eine Feingoldschicht abzuscheiden, vorzugsweise lmm dick, und so die Bondflächen (9) zu bilden. Vor oder nach dem galvanischen Beschichten, vorzugsweise vor dem galvanischen Beschichten, werden die im Halbzeug noch zusalmmenhängenden Kontaktstifte U-förmig abgewinkelt, wie in Figur 7 dargestellt. Das kann mit Hilfe eines Stanz-Biegewerkzeugs geschehen, mit welchem das bandförmige Halbzeug zugleich vorgestanzt wird, wie es in Figur 5 dargestellt ist.

Nach dem Erzeugen der Bondfläche (9) können die Kontaktstifte (5) an den dafür vorgesehenen Trennstellen (21) und (22) abgeschnitten und von Hand oder maschinell mittels eines Eandhabungswerkzeuges in den Träger (1) eingepreßt werden. Da die Bondfläche (9) sich nur über einen Teil des abschnittes (8) erstreckt, kann der erforderliche Preßdruck aufgebracht werden, ohne die Bondfläche (9) zu berühren, so daß diese keinerlei Beeinträchtigung ihrer Bondfähigkeit erfährt.

Durch die Verzahnungen (Taille 13, Zähne 16) sowie durch den spitz zulaufenden Abschnitt (17) erhalten die Kontaktstifte einen sehr guten Festsitz im Träger (1). Um die Löcher (10) abzudichten und dadurch hermetisch dichte Gehäuse zu erhalten, kann man die Kontaktstifte (5) mit einem Gießharz (23) vergießen. Zu diesem Zweck ist in der Oberseite (24) des Bodens, in der Terminologie der Ansprüche als "erste Seite" bezeichnet, eine Vertiefung (25) vorgesehen, welche das Gießharz (23) aufnimmt. Unter dem bondbaren Abschnitt (8) des Kontaktstiftes ist eine zusätzliche Vertiefung (26) vorgesehen, um das Eindringen von Gießharz unter den Abschnitt (8) zu erleichtern. Auf diese zusätzliche Absenkung (26) kann man gut verzichten, wenn man die Löcher (10) nicht mit Gießharz abdichtet, sondern statt dessen die längeren Schenkel (6) in ihrem Bereich (15), welcher in den Kunststoff des Trägers (1) eingebettet wird, mit einem Schmelzkleber ummantelt, der nach dem Einpressen der Kontaktstifte (5) in den Träger (1) durch Erwärmen aktiviert wird. In diesem Fall kann die Oberseite (24) des Trägers (1) zusätzlich unterstützend für den Abschnitt (8) wirken.

In ihrem über die Unterseite (in der Terminologie der Patentansprüche die "zweite Seite") des Trägers (1) vorstehenden Abschnitte (27) der längeren Schenkel (6) können zum Zwecke der Lötbarmachung galvanisch mit einer lötfähigen Schicht (28) versehen sein (Figur 7), z. Bsp. mit einer 10-15mm dicken Schicht aus Zinn mit 10% Blei.

## Patentansprüche

1. Träger aus einem Kunststoff für eine elektronische Schaltung, mit Kontaktstiften (5), welche den Träger (1) durchsetzen und auf einer ersten Seite (24) des Trägers (1) einen bondbaren Abschnitt (8) haben, welcher zum Anschließen der Schaltung mittels Drähten dient, die durch Bonden mit den Kontaktstiften (5) zu verbinden sind, wohingegen die Kontaktstifte (5) von einer der ersten Seite (24) des Trägers (1) abgewandten zweiten Seite hervorstehen, **dadurch gekennzeichnet,** daß die Kontaktstifte (5) an ihrem einen Ende unter Bildung von zwei ungleich langen Schenkeln (6,7) U-förmig derart abgewinkelt sind, daß der bondbare Abschnitt (8) die beiden Schenkel(6,7) verbindet, der längere Schenkel (6) den Träger (1) durchsetzt und der kürzere Schenkel (7) in den Träger (1) eindringt.

2. Träger nach Anspruch 1, **dadurch gekennzeichnet,** daß der kürzere Schenkel (7) in einem Sackloch (11) des Trägers (1) steckt.

3. Träger nach Anspruch 1 oder 2, **dadurch gekennzeichnet,** daß die Kontaktstifte (5) ein flaches, insbesondere rechteckiges Profil haben.

4. Träger nach einem der Ansprüche 1 bis 3, **dadurch gekennzeichnet,** daß die Kontaktstifte (5) in ihrem im Träger (1) verlaufenden Abschnitt (15) gezahnte Ränder (16) haben.

5. Träger nach einem der vorstehenden Ansprüche, **dadurch gekennzeichnet,** daß der längere Schenkel (6) mit einem spitz zulaufenden Abschnitt (17) im Träger (1) steckt.

6. Träger nach einem der vorstehenden Ansprüche, **dadurch gekennzeichnet,** daß die zum Aufnehmen der Kontaktstifte (5) im Träger (1) erforderlichen Löcher (10,11) durch Spritzgießen des Trägers (1) geformt sind.

7. Träger nach einem der vorstehenden Ansprüche, **dadurch gekennzeichnet,** daß der bondbare Abschnitt (8) so dicht an der ersten Seite (24) des Trägers (1) liegt, wie es die Biegeradien des Kontaktstiftes (5) erlauben.

8. Träger nach einem der vorstehenden Ansprüche, **dadurch gekennzeichnet,** daß der bondbare Abschnitt (8) durch die erste Seite (24) des Trägers (1) unterstützt ist.

9. Träger nach einem der vorstehenden Ansprüche, **dadurch gekennzeichnet,** daß die Kontaktstifte (5) auf der ersten Seite (24) des Trägers (1) bis unterhalb der Oberseite (9) ihres bondbaren Abschnitts (8) in ein Gießharz (23) eingegossen und zu diesem Zweck in einer Vertiefung (25,26) der ersten Seite (24) des Trägers (1) angeordnet sind.

10. Träger nach einem der vorstehenden Ansprüche, **dadurch gekennzeichnet,** daß die Kontaktstifte (5) in ihrem im Träger (1) liegenden Abschnitt (15) des längeren Schenkels (6) von einem Schmelzkleber umgeben sind.

11. Träger nach einem der vorstehenden Ansprüche, **dadurch gekennzeichnet,** daß die Kontaktstifte (5) in ihrem bondbaren Abschnitt (8) mit Gold beschichtet sind.

12. Träger nach einem der vorstehenden Ansprüche, **dadurch gekennzeichnet,** daß die Kontaktstifte (5) in ihrem über die zweite Seite des Trägers (1) hervorstehenden Abschnitt (27) ihres längeren Schenkels (6) mit einer weichlötbaren Schicht (28) versehen sind.

## Claims

1. A support made of plastics material for an electronic circuit, having contact pins (5) which pass through the support (1) and have a bondable portion (8) on a first side (24) of the support (1), this bondable portion (8) serving to connect the circuit by means of wires which are to be connected by being bonded to the contact pins (5), in opposition to which the contact pins (5) project from a second side remote from the first side (24) of the support (1), characterized in that the contact pins (5) are bent round at their one end in a U shape, forming two limbs (6, 7) of unequal length, in such a way that the bondable portion (8) connects the two limbs (6, 7), the longer limb (6) passes through the support (1) and the shorter limb (7) penetrates into the support (1).

2. A support according to Claim 1, characterized in that the shorter limb (7) lies inside a blind hole (11) in the support (1).

3. A support according to Claim 1 or 2, characterized in that the contact pins (5) have a flat, in particular a rectangular profile.

4. A support according to one of Claims 1 to 3, characterized in that the contact pins (5) have toothed edges (16) in their portion (15) extending inside the support (1).

5. A support according to one of the preceding claims, characterized in that the longer limb (6) has a sharply tapering portion (17) lying inside the support (1).

6. A support according to one of the preceding claims, characterized in that the holes (10, 11) required to receive the contact pins (5) in the support (1) are moulded by injection moulding the support (1).

7. A support according to one of the preceding claims, characterized in that the bondable portion (8) lies as closely against the first side (24) of the support (1) as the radii of curvature of the contact pins (5) will allow.

8. A support according to one of the preceding claims, characterized in that the bondable portion (8) is supported by the first side (24) of the support (1).

9. A support according to one of the preceding claims, characterized in that the contact pins (5) are cast in a casting resin (23) on the first side (24) of the support (1) reaching below the upper side (9) of their bondable portion (8), and to this end are arranged in a depression (25, 26) in the first side (24) of the support (1).

10. A support according to one of the preceding claims, characterized in that the contact pins (5) are surrounded by a hot-melt adhesive in their portion (15) of the longer limb (6) lying within the support (1).

11. A support according to one of the preceding claims, characterized in that the contact pins (5) are coated with gold in their bondable portion (8).

12. A support according to one of the preceding claims, characterized in that the contact pins (5) are provided with a soft-solderable layer (28) in their portion (27) of their longer limb (6) projecting beyond the second side of the support (1).

## Revendications

1. Support en matière synthétique pour un circuit électronique, comprenant des connecteurs mâles (5) qui traversent le support (1) et qui possèdent, sur un premier côté (24) du support (1), une section (8) permettant de réaliser l'interconnexion, qui sert au raccordement du circuit au moyen de fils qui doivent être reliés par interconnexion avec les connecteurs mâles (5), tandis que les connecteurs mâles (5) font saillie par rapport à un second côté se détournant du premier côté (24) du support (1), caractérisé en ce que les connecteurs mâles (5) sont pliés en U à une de leurs extrémités en formant deux branches (6, 7) de longueur inégale, de telle sorte que la section (8) permettant de réaliser l'interconnexion relie les deux branches (6, 7), la branche plus longue (6) traverse le support (1) et la branche plus courte (7) pénètre dans le support (1).

2. Support selon la revendication 1, caractérisé en ce que la branche plus courte (7) vient s'enficher dans un trou borgne (11) du support (1).

3. Support selon la revendication 1 ou 2, caractérisé en ce que les connecteurs mâles (5) possèdent un profil plat, en particulier rectangulaire.

4. Support selon l'une quelconque des revendications 1 à 3, caractérisé en ce que les connecteurs mâles (5) possèdent des bords dentelés (16) dans leur section (15) s'étendant dans le support (1).

5. Support selon l'une quelconque des revendications précédentes, caractérisé en ce que la branche plus longue (6) vient s'enficher dans le support (1) avec une section (17) se terminant en pointe.

6. Support selon l'une quelconque des revendications précédentes, caractérisé en ce que les trous (10, 11) requis pour l'insertion des connecteurs mâles (5) dans le support (1) sont réalisés par moulage par injection du support (1).

7. Support selon l'une quelconque des revendications précédentes, caractérisé en ce que la section (8) permettant de réaliser l'intérconnexion est située aussi près du premier côté (24) du support (1) que ne le permettent les rayons de courbure des connecteurs mâles (5).

8. Support selon l'une quelconque des revendications précédentes, caractérisé en ce que la section (8) permettant de réaliser l'interconnexion est supportée par le premier côté (24) du support (1).

9. Support selon l'une quelconque des revendications précédentes, caractérisé en ce que les connecteurs mâles (5) sont coulés dans une résine de coulée (23) sur le premier côté (24) du support (1) jusqu'à un endroit situé en dessous du côté supérieur (9) de leur section (8) permettant de réaliser l'interconnexion et sont disposés à cet effet dans un renfoncement (25, 26) du premier côté (24) du support (1).

10. Support selon l'une quelconque des revendications précédentes, caractérisé en ce que les connecteurs mâles (5) sont entourés d'un adhésif à fusion dans leur section (15) de la branche plus longue (6), située dans le support (1).

11. Support selon l'une quelconque des revendications précédentes, caractérisé en ce que les connecteurs mâles (5) sont recouverts d'or dans leur section (8) permettant de réaliser l'interconnection.

12. Support selon l'une quelconque des revendications précédentes, caractérisé en ce que les connecteurs mâles (5) sont munis d'une couche (28) apte à un brasage tendre dans leur section (27) de leur branche plus longue (6), faisant saillie au-delà du second côté du support (1).
